Europäisches Patentamt

European Patent Office

Office européen des brevets

(19)

(11) Publication number: **0 240 102**
**A2**

# (12) EUROPEAN PATENT APPLICATION

(21) Application number: 87300478.2

(22) Date of filing: 20.01.87

(51) Int. Cl.4: **G01R 21/00** , G01R 31/28 , G01R 35/04

(30) Priority: 31.03.86 US 846355

(43) Date of publication of application:
**07.10.87 Bulletin 87/41**

(84) Designated Contracting States:
**AT BE CH DE ES FR GB GR IT LI LU NL SE**

(71) Applicant: ROBINTON PRODUCTS INC.
580 Maude Court P.O. Box 61929
Sunnyvale California 94086(US)

(72) Inventor: Dawson, Lev M.
20727 Russell Lane
Saratoga California 95070(US)
Inventor: Robinton, Michael A.
812 Los Robles
Palo Alto California 94306(US)
Inventor: Starkie, Alan H.
3438 Fawn Drive
San Jose California 95124(US)

(74) Representative: Williams, Trevor John et al
J.A. KEMP & CO. 14 South Square Gray's Inn
London WC1R 5EU(GB)

(54) **Power meter having self-test function.**

(57) An electronic metering system having self-test capabilities. First and second analog signals are produced which are indicative of the voltage and current, respectively, carried on a line. The first analog signal is modulated to provide a digital signal changeable between two levels at predetermined clock times. The ratio of duration of the signal at one level to that of the second level is proportional to the line voltage. The modulated signal and second analog signal are multiplied together to produce a product signal which represents power carried on the line in either direction. The product signal is converted to a train of pulses, with each pulse representing a predetermined amount of power. Self-test capability is provided wherein a test signal is momentarily substituted for the first analog signal, with the test signal corresponding to a line voltage of zero magnitude. A comparator is provided for confirming that the converted product signal corresponds to zero power carried on the line in either direction when the test signal is applied. If the converted signal differs from zero power more than a predetermined amount, an error signal is produced indicating a meter system malfunction.

FIG. 1.

## POWER METER HAVING SELF-TEST FUNCTION

### Field of the Invention

The present invention relates generally to the field of electrical measuring apparatus and, more particularly, an electrical power metering system having self-testing capabilities.

### Background Art

Electrical power meters, including electronic meters, are presently available which are capable of accurately monitoring electrical power consumption. Such meters must meet high standards of reliability, especially in those instances wherein a consumer is billed for energy measured by the meter.

In order to verify meter accuracy, heretofore it has been necessary to utilize a reference meter of known accuracy to monitor the load measured by the meter under test. Alternatively, it has been necessary to replace the load connected to a meter with a known test load. In either case, monitoring meter accuracy is time consuming, and otherwise expensive, especially when a meter is located at a remote site. In addition, unless a meter is tested on a frequent basis, it is likely that inaccurate meter readings will take place over a significant amount of time until the malfunction is detected.

The present invention overcomes the above-noted limitations of conventional electronic power meters. In a preferred embodiment, a known test voltage is automatically momentarily applied to one of either a voltage or current input of the meter system. The meter output and intermediate points of the meter are compared with internally-storedreference values. In the event the output and/or intermediate metering points differ from the corresponding stored references more than a predetermined amount, an appropriate error signal is generated.

In remote metering applications, power consumption is frequently transmitted over telephone lines or the like. In that event, the error signal can also be transmitted so that a meter malfunction can be detected quickly and without the necessity of traveling to the meter installation.

The above-noted advantages of the present invention and further advantages will become apparent to persons skilled in the art upon a reading of the following Best Mode for Carrying Out the Invention together with the drawings.

### Disclosure of the Invention

An electronic metering system having self-test capabilities is disclosed. The system includes apparatus for producing a first analog signal indicative of either the line voltage or current and a second analog signal indicative of the other of the line voltage and current.

A modulator is provided which produces a first modulated signal from the first analog signal, with the modulated signal being changeable between first and second levels. The first modulated signal and the second analog signal are utilized by a multiplier to produce a first product signal indicative of power carried on the line. The first product signal is fed to a converter which converts the signal to a train of pulses, with each pulse representing a predetermined amount of power carried on the line.

The metering system includes a self-test apparatus for momentarily applying a predetermined first test signal to the input of the modulator in lieu of the first analog signal. The first test signal causes the output of the converter to produce a converted signal which corresponds to the first test signal. Preferably, the first test signal is at ground potential so that the converter output will indicate zero power on the line, independent of the magnitude of the second analog signal. A test signal at ground potential can be simulated by opening the input to modulator 22 utilizing switch $S_3$

A first converted signal value is stored which corresponds to the first test signal. In the event the first test signal is ground potential, the stored first converted signal value will represent zero power. A comparator is provided for producing an error signal should the first converted signal differ from the stored first converted signal value more than a predetermined amount when the first test signal is applied to the input of the modulator.

A first modulated signal value can be stored which also corresponds to the first test signal. The stored first converted and first modulated signal values will represent zero power and zero line current/voltage, respectively, in the event the first test signal is at ground potential. A second comparator is provided for producing an error signal should the first modulated signal differ from the stored first modulated signal value more than a predetermined amount.

Preferably, one or more other test signals are also momentarily applied to the input of the converter, in lieu of the product signal, so as to simulate non-zero power consumption/production by the load. The output of the converter is compared with a stored reference value and an additional error signal is produce if the converted signal differs from the stored value more than a predetermined amount.

## Brief Description of the Drawing

Figure 1 is a block diagram of an preferred embodiment power metering system in accordance with the present invention.

Figure 2 is a table depicting the state of various system components during the operating and self-test modes of the subject metering system.

## Description of the Preferred Embodiment

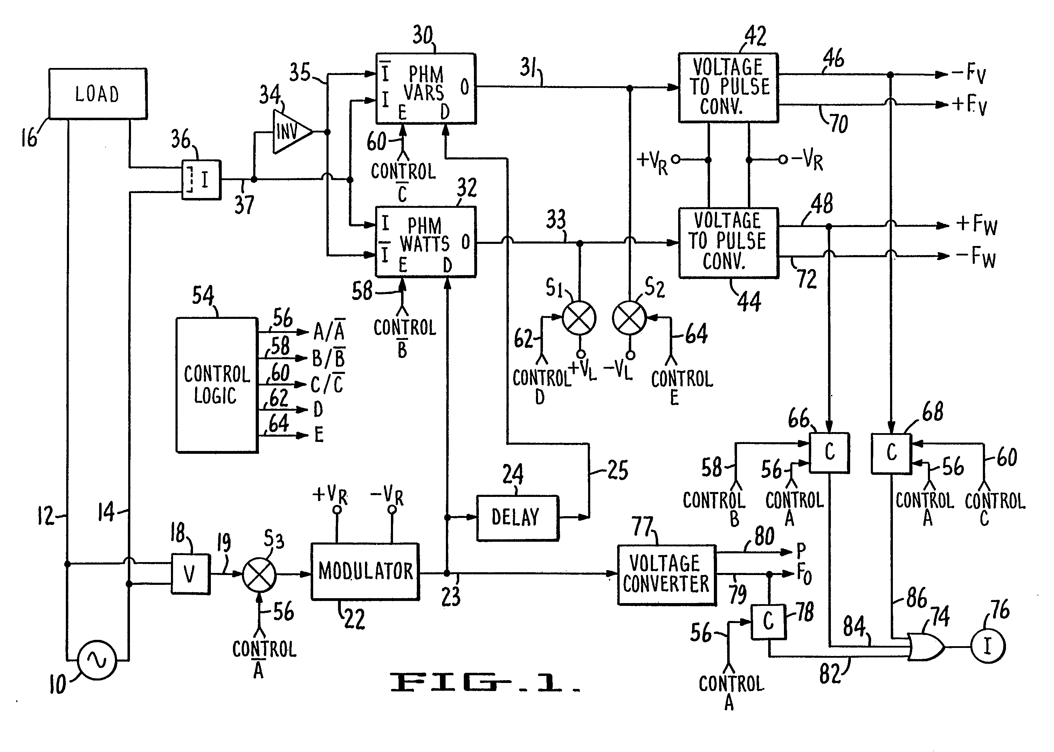

Referring now to the drawings, an exemplary power metering apparatus in accordance with subject invention is depicted in Figure 1. Further details regarding the construction of such a power metering apparatus, without the self-test features of the subject invention, are disclosed in U.S. Patent No. 4,573,037, issued on February 25, 1986 and entitled "Analog-To-Digital Converter and Method", the contents of which are hereby fully incorporated herein by reference. In order to avoid obscuring the true nature of the subject invention in unnecessary detail, many aspects of the metering apparatus which do not relate to the invention are not depicted in the drawings.

An AC power source is represented by element 10. The power source is a single phase source although the subject invention can also be used in conjunction with power metering of multiple phase sources. Power source 10 is connected to a load 16 by way of lines 12 and 14. Load 16 may consume electrical power and may also generate electrical power in the event the load includes an electrical generator.

The power meter includes a voltage sensor, such as a resistor network, represented by block 18, connected to power lines 12 and 14. The voltage sensor 18 output is connected to a line 19. A bipolar voltage is present on line 19 which is representative of the instantaneous voltage across the power lines.

Line 19 is coupled to the input of SPST analog switch $S_3$. Switch $S_3$ is controlled by a digital signal on line 56, referred to as signal Control $\overline{A}$ which is the inverse of signal Control A. These control signals and others are produced by logic circuitry represented by block 54. Details regarding signal Control $\overline{A}$ and other control signals will be subsequently setforth.

The output of switch $S_3$ is connected to the input of a modulator 22. Modulator 22 is a delta-minus-sigma type of modulator which utilizes a positive voltage reference $+V_R$ and a negative voltage reference $-V_R$. Details regarding the construction of a suitable modulator are set forth in the previously-noted U.S. Patent No. 4,573,037.

The output of modulator 22 on line 23 is a digital signal changeable between two levels at predetermined clock times, with the clock frequency being substantially greater than the line frequency. The digital oput has an average value over time which is proportional to the amplitude of the line voltage. If the instantaneous line voltage is at zero volts, the output of modulator 22 will be in high and low states an equal period of time. If the voltage is positive the ratio of high level to low level will be less than 50% and for a negative voltage, the ratio will be greater than 50%.

The output of modulator 22 is connected to a delay circuit 24, which is preferably a shift register, which introduces a predetermined delay in the output. Circuit 24 introduces a delay equivalent to a ninety (90°) degree phase shift with respect to the power frequency. The output is used to produce a VARS power measurement in addition to a WATTS measurement, as will be subsequently described.

The delayed or phase-shifted modulator output of circuit 24 is coupled to a digital input D of a pulse height modulator 30 by way of line 25. The undelayed output of the modulator 22 on line 23 is connected to a digital input D of a second pulse height modulator 32. Modulators 30 and 32 are each provided with enable inputs E which, when low, cause the output of the associated modulator to switch to a high impedance state whereby the associated modulator is disabled. The enable inputs E of modulators 30 and 32 are connected to lines 60 and 58, respectively, which carry respective signals Control $\overline{C}$ and Control $\overline{B}$

The output of modulator 22 is further connected to logic circuitry represented by block 77. The logic circuitry serves to convert the output of modulator 22 to a digital signals $F_0$ and P on lines 79 and 80, respectively. Signal $F_0$ has a pulse repetion rate which is proportional to the magnitude of the voltage fed into modulator 22 and signal P is indicative of the polarity. Circuitry for providing voltage signals $F_0$ and P is disclosed in Application Serial No. 536,558 filed on September 27, 1983 and entitled "Analog-To-Digital Converter and Method", the contents of which are hereby incorporated herein by reference.

Digital signal $F_0$ is connected to the input of a comparator circuit 78 which compares the signal with an internal reference. Comparator 78 has an enable input which is connected to line 56 which carries digital signal Control A. When the comparator is enabled by Control A, signal $F_0$ is compared with an internal reference. In the event the difference between signal $F_0$ and the reference exceeds a predetermined maximum value, the normally-low digital output of comparator 78 on line 82 goes to a logic high. Line 82 is connected to one input of a three-input OR gate 74. The output of gate 74 is connected to a visual indicator represented by element 76 mounted on the front panel (not shown) of the subject meter apparatus. When the output of gate 78 goes high, indicator 76 will show that a measurement malfunction has occurred. Indicator 76 includes an associated latch (not shown) which is set by gate 78 so that the indicator will remain activated. In the event power consumption data is transmitted over a telephone line or the like to a central office, an error message is also preferably transmitted over the line when the output of gate 74 goes high.

A current sensing circuit 36 is connected in series with power line 14. Circuit 36 produces a bipolar signal on output line 37 having a magnitude proportional to the magnitude of the current flow to or from the load. The circuit preferably includes a transformer having a primary winding connected in series with power line 14, a secondary winding with a current sensing resistor connected in parallel, and a buffer amplifier.

The output of current sense circuit 36 on line 37 is connected to an analog input I of each of the pulse height modulators 30 and 32. The output is also connected to an analog inverting circuit 34 which may be an inverting-configured operational amplifier. The output of the inverter circuit 34 on line 35 is coupled to analog inputs $\overline{I}$ of the respective pulse height modulators 30 and 32.

The pulse height modulators 30 and 32 each effectively couple either input I or input $\overline{I}$ to output O, depending upon the state of digital input D. Each modulator may be implemented, for example, by utilizing a pair of digitally-controlled SPST analog switches and a digital invertor, with the digital input D controlling one analog switch of the multiplier and the inverse of D controlling the remaining switch. Enable input E functions to override input D and turn off both switches of the modulator thereby disabling the modulator.

The outputs of the two pulse height modulators 30 and 32, on respective lines 31 and 33, are coupled to respective voltage-to-pulse converters 42 and 44. Converters 42 and 44 both utilize positive and negative voltage references $+V_R$ and $-V_R$. Converters 42 and 44 serve to integrate the outputs of modulators 30 and 32 and produce pulse train outputs having a pulse frequency which is proportional to the magnitude of the integral of the input. Each pulse represents a predetermined amount of power, with the total number of pulses representing energy command or generated. Two outputs are provided for each converter, including outputs $+F_w$ of converter 42 which indicates the amount of power in watts consumed by load 16 and output $-F_w$ which indicates the amount of power in watts provided by the load. The outputs $+F_v$ and $-F_v$ of converter 42 are of indicative the amount of power in VARS consumed and generated, respectively, by load 16. As is well known, the WATTS and VARS measurements may then be used to compute a power factor value equal to cosine $\phi$, where $\phi$ is the phase angle between the voltage and current at the load.

The subject apparatus further includes a pair of SPST analog switches $S_1$ and $S_2$. Switch $S_1$ has one terminal connected to a positive voltage source $+V_L$ and the remaining terminal coupled to line 33 which is connected to the input of converter 44. Switch $S_2$ has one terminal connected to the input of converter 42 and the other terminal connected to a negative voltage source $-V_L$. Voltage sources $+V_L$ and $-V_L$ are provided by regulated power supplies and are utilized primarily for powering the various individual circuits of the subject power meter apparatus and are approximately $+5$ volts and $-5$ volts, respectively. Preferably, the regulated power supplies utilize regulators different than those utilized to produce reference voltages $+V_R$ and $-V_R$.

Switch $S_1$ couples and uncouples voltage $+V_L$ to the input on converter 44 in response to a digital signal Control D on line 62. Similarly, Switch $S_2$ couples and uncouples voltage $-V_L$ to the input of converter 42 in response to a digital signal Control E on line 64.

Outputs $+F_v$, $-F_v$, $+F_w$ and and $-F_w$ of converters 42 and 44 are preferably connected to separate counters (not depicted) which accumulate the various pulses over time. Accordingly, the outputs of the counters represent energy consumed and generated by load 16 in terms of Watt-hours and VAR-hours.

Output $+F_w$ on line 48 is also connected to the input of a second comparator 66 having two stored reference values. Comparator 66 has a pair of enable inputs, including a first input connected to line 56 which carries digital signal Control A and a second input connected to line 58 which carries digital signal Control B. The normally-low output of comparator 66 on line 84 is connected to a second input of OR gate 74.

Signals Control A and B cause input $+F_w$ to be compared with the first and second internal references, respectively. If $+F_w$ differs from the applicable reference more than a predetermined amount, the output of the comparator 66 goes high thereby indicating an error.

A third comparator 68 is provided having an input which is connected to line 46 which carries output $+F_v$. The comparator includes two internal reference values and a pair of enable inputs connected to lines 58 and 60 which carry signals Control A and Control C, respectively.

Signals Control A and Control C cause output $+F_v$ to be compared with first and second interval references, respectively. In the event the difference between output $+F_w$ and the associated references exceed a predetermined value, the normally-low output of the comparator 68 on line 86, which is connected to third input OR gate 74, will go high.

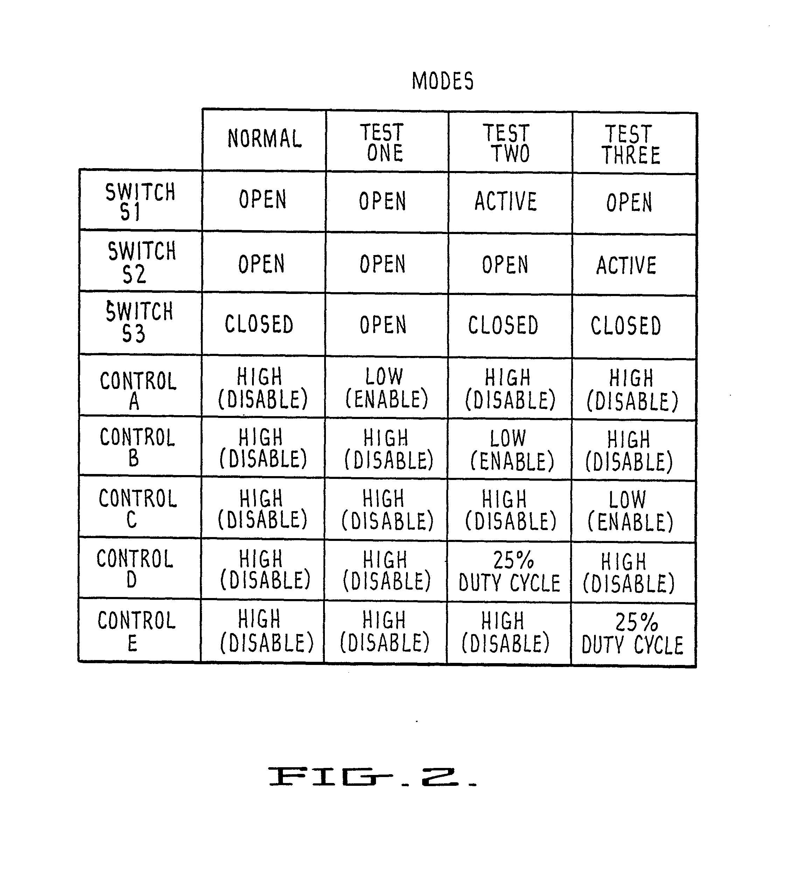

The table depicted in Figure 2 shows the various modes in which the subject power metering system operates. In the Normal mode, the subject system provides an output indicative of power consumed/produced by the load in both Watts ($F_w$) and VARS ($F_v$). An output is also provided indicative of the line voltage ($F_o$).

As shown in the Figure 2 table, switches $S_1$ and $S_2$ are both open in the Normal mode. Signals Control D and E, which control the state of the two respective switches, are both in a high (disable) state in the normal mode. These control signals, together with the remaining control signals, are produced by conventional circuitry represented by block 54, as previously noted. In addition, signals Control B and C are high so that inverse signals $\overline{B}$ and $\overline{C}$ will cause the two pulse height modulators 30 and 32 to be enabled. Finally, signal Control A is high in the Normal mode so that signal $\overline{A}$ applied to Switch $S_3$ will cause the switch to be closed.

In the Normal mode, modulator 22 will produce a digital output having a high state/low state ratio proportional to the line voltage. Delay 24 will produce a similar signal which is delayed in time an amount which is equivalent to a 90° phase shift of the line voltage. The two outputs will control respective pulse height modulators 30 and 32 by alternately coupling the line current signals at inputs I and $\overline{I}$ to the respective modulator outputs.

The outputs of modulators 30 and 32 will have a pulse width proportional to the line voltage and a pulse height proportional to line current. Accordingly, the integral of the output of the modulators will be indicative the power consumed/produced by load 16. Voltage to pulse converters 42 and 44 function as low pass filters so as to produce internal signals proportional to power. The internal signal are used to gate a pulse train on and off so as to produce pulses $F_v$ and $F_w$ which can be accumulated over time so as to provide an indication of energy consumed/produced.

Voltage converter 77 operates in a manner similar to converters 42 and 44 and acts as a low pass filter so as to convert the output of modulator 22 to a signal $F_o$ indicative of the magnitude of the line voltage. In the event the modulator 22 output changes state every modulator clock time, the voltage magnitude is assumed to be zero. If the output level remains at a first level for two consecutive modulator clock times the voltage is of a first polarity and if the level remains at a second level for two consecutive clock times, the polarity is assumed to be of a second polarity, opposite the first polarity. Signal P on line 80 is provided which indicates the polarity of voltage signal $F_o$.

In the Test One mode, the Figure 2 Table indicates that switches $S_1$, $S_2$ and $S_3$ are all opened. Signal Control A is low (enabled) and signals Control B-E are high (disabled). With switch $S_3$ open, the voltage input to modulator 22 is at ground potential so as to simulate a line voltage of zero volts. The output of converter 77, signal $F_o$, is compared to an internal reference which corresponds to zero volts by comparator 78, with the comparator being enabled by signal Control A. In the event signal $F_o$ differs from zero volts by more than a predetermined error value, the output of comparator 78 on line 82 will go high, thereby activating indicator 76. In addition, an error message will preferably be transmitted to a central office, in the event a data link is present.

Inasmuch as Test One simulates a line voltage of zero volts, the power on the line should also be zero. Thus, the outputs of modulator 23 and delay circuits 24 should cause the two pulse height modulators 30 and 32 to switch between the current signals at inputs I and $\overline{I}$ an equal amount of time so that the integral of the outputs of converters 42 and 44 is zero.

The output $+F_w$ of converter 44 is compared to an internal reference by comparator 66. Comparator 66 is enabled by signal Control A, with the signal selecting an internal reference which corresponds to zero WATTS. In the event $+F_w$ falls outside a predetermined guard band, comparator 66 will cause an error indication by way of OR gate 74. Comparator 68, which is also enabled by signal Control A, will make a similar test of VARS signal $+F_v$ which should also be at zero.

It can be seen that the Test One mode partially tests the operation of voltage modulator 22, delay 24, voltage converter 77, plus height modulators 30, 32 and pulse converters 42 and 44.

Referring again to Figure 2, a Test Two mode is entered wherein switch $S_1$ is active, switch $S_2$ is opened and switch $S_3$ is closed. Signal Control B is low so that modulator 32 will be disabled and

comparator 66 will be enabled. Signal Control D will have a duty cycle of 25% wherein logic voltage $+V_L$ will be applied to the input of converter 25% of the time by way of switch $S_1$.

Assuming that voltage $+V_L$ is $+5$ volts, and that reference voltages $+V_L$ and $-V_R$ are $+2.5$ volts and $-2.5$ volts respectively, the 25% duty cycle will simulate a power measurement of 50% maximum scale. Thus, if signal $+F_w$ has a minimum value of zero pulses/second and a maximum of 1800 pulses/second, $+F_w$ would nominally be at a pulse rate of 900 pulses/second. As set forth in previously-noted U.S. Patent No. 4,573,037, when a positive input is applied to converter 44 (or converter 42), the converter utilizes the negative reference voltage $-V_R$.

Signal Control B will cause a stored reference value internal to comparator 66, which corresponds to 900 pulses/second, to be compared with $+F_w$. In the event $+F_w$ falls outside a predetermined guard band, an error signal will be produced on line 84 which will activate indicator 76 to indicate an error.

It can be seen that the Test Two mode confirms partial operation of converter 44, together with the relative magnitude of voltages $+V_L$ and $-V_R$.

In the Test Three mode, switch $S_3$ is closed, switch $S_1$ is open and switch $S_2$ is active. The Test Three mode is similar to Test Two mode with logic voltage $-V_L$ being applied to the input of converter 42 25% of the time. Converters 42 and 44 utilize positive reference $+V_R$ for converting negative inputs. Signal Control E functions to couple voltage $-V_L$ -25% of the time to the input of converter 42, with signal $\overline{C}$ disabling modulator 30. Signal C enables comparator 68 and causes an internal reference which corresponds to a negative VARS measurement $-F_v$ of 50% maximum scale. The Test Three mode serves to test the operation of converter 42 and the relative magnitudes of logic voltage $-V_L$ and reference voltage $+V_R$. In the event a single converter 42, 44 is utilized (thus, no power factor measurement can be made) references $+V_R$ and $-V_R$ are preferably tested by applying both voltages $+V_L$ and $+V_L$ to the converter input during respective modes.

Logic voltages $+V_L$ and $-V_L$ are typically not precision references, but the magnitude of such voltages should change little once the metering system has been constructed. Preferably, once the meter has been constructed, proper operation is confirmed utilizing automated test equipment. The nominal outputs of converters 44, 46 and 77, which are tested during the three modes, are measured and stored in a non-volatile memory (not shown) associated with comparators 66, 68 and 78. These stored values can then be utilized by the comparators as reference test values. Any deviation from these reference values outside of a predetermined guard band will indicate a meter malfunction.

The disclosed metering system is especially adapted to be implemented in integrated circuit form. Many of the comparator functions performed by the comparators 66, 68 and 78 and other functions, such as the generation of signals Control A-E, can be implemented utilizing a suitably-programmed microprocessor which forms part of the meter.

Inasmuch as the meter systems is not operational during the various self-test modes, self-testing must be accomplished quickly so as to minimize metering inaccuracy. Given the response time of a typical meter, a self-test once per 24 hour period of a total duration of approximately 10 seconds, wherein each test mode is entered, has been found satisfactory. The timing of the test modes is determined by signals Control A-E, with the signals all normally being high as shown in the Figure 2 table.

Thus, a novel metering system having self-test capabilities has been disclosed. Although a preferred embodiment of the system has been described in some detail, it is to be understood that various changes can be made by persons skilled in the art without departing from the spirit and scope of the invention as defined by the appended claims.

## Claims

1. An electrical power meter having internal self-test capabilities, said meter comprising:
monitoring means for producing a first analog signal indicative of one of voltage and current carried on a line and for producing a second analog signal indicative of the other of said voltage and current;
first modulator means for producing a first modulated signal changeable between two levels and indicative of the magnitude of said first analog signal;
first multiplying means for producing a first product signal, from said first modulated signal and said signal analog signal, which is indicative of power carried on the line;
first converter means for producing a first converted signal from said first product signal in the form of a train of pulses, with each of said pulses representing a predetermined amount of power carried on the line;
first test means for momentarily applying a predetermined first test signal to an input of said first modulator means in lieu of said first analog signal;
first memory means for storing a first converted signal value which corresponds to said first test signal; and

first comparator means for producing a first error signal when said first converted signal differs from said stored first converted signal value more than a predetermined amount when said first test signal is applied to said first modulator means input.

2. The power meter of Claim 1 wherein said first test signal corresponds to said first analog signal of zero amplitude and said stored first converted signal value corresponds to power carried on the line of zero amplitude.

3. The power meter of Claim 1 further including second memory means for storing a first modulated signal value which corresponds to said first test signal and second comparator means for producing a second error signal when said first modulated signal differs from said stored first modulated signal value by more than a predetermined amount when said first test signal is applied to said first modulator means.

4. The power meter of Claim 1 further including:

second test means for momentarily applying a predetermined second test signal to an input of said first converter means in lieu of said first product signal;

third memory means for storing a second converted signal value which corresponds to said second test signal; and

third comparator means for producing a third error signal when said first converted signal differs from said stored second converted signal value more than a predetermined amount when said second test signal is applied to said first converter means input.

5. The power metering system of Claim 4 wherein said first converter means utilizes a first reference voltage and wherein said second test signal is derived independent of said first reference voltage.

6. The power metering system of Claim 5 wherein said power meter further includes:

delay means for producing a delayed first modulated signal delayed a predetermined period of time with respect to said first modulated signal;

second multiplying means for producing a second product signal, from said delayed modulated signal and said second analog signal, which is indicative of power carried on the line;

second converter means for producing a second converted signal from said second product signal in the form of a train of pulses, with each of said pulses representing a predetermined amount of power carried on the line;

third test means for momentarily applying a predetermined third test signal to an input of said second converter means in lieu of said second product signal;

fourth memory means for storing a third converted signal value which corresponds to said third test signal; and

fourth comparator means for producing a fourth error signal when said second converted signal differs from said stored third converted signal value more than a predetermined amount when said third test signal is applied to said second converter means input.

7. The power meter of Claim 6 wherein said second converter means utilizes a second reference voltage having a polarity opposite to that of said first reference voltage reference and wherein said third test signal is derived independent of said second reference voltage.

8. The power meter of Claims 7 wherein said first and second voltage references are of opposite polarity and wherein said second and third test signals are of opposite polarity.

9. An electrical power meter having internal self-test capabilities comprising:

monitoring means for producing a first signal indicative of one of voltage and current carried on a line and a second signal indicative of the other of voltage and current on the line;

first multiplying means for producing a first product signal comprised of a series of pulses having a pulse width which corresponds to said first signal and a pulse height which corresponds to said second signal;

first converter means for producing a first converted signal from said first product signal indicative of power carried on the line;

first test means for momentarily applying a predetermined first test signal to an input of said first converter means in lieu of said first product signal;

first memory means for storing a first converted signal value which corresponds to said first test signal; and

first comparator means for producing a first error signal when said first converted signal differs from said stored first converted signal value more than a predetermined amount when said first test signal is applied to said first converter means.

10. The power meter of Claim 9 further including:

second multiplying means for producing a second product signal comprised of a series of pulses having a pulse width which corresponds to said first signal delayed in time and a pulse height which corresponds to said second signal;

second converter means for producing a second converted signal from said second product signal indicative of power carried on the line;

second test means for momentarily applying a predetermined second test signal to an input of said second converter means in lieu of said second product signal;

second memory means for storing a second converted signal value which corresponds to said second test signal; and

second comparator means for producing a second error signal when said second converted signal differs from said stored second converted signal value more than a predetermined amount when said second test signal is applied to said second converter means.

11. The power meter of Claim 10 wherein said first and second converter means both utilize reference voltages of opposite polarity and wherein said first and second test signals are of opposite polarity.

12. The power meter of Claim 11 wherein said first and second test signals are derived independent of said reference voltages.

13. The power meter of Claim 11 further including:

first modulator means for producing a first modulated signal changeable between two levels and indicative of the magnitude of said first signal;

third test means for momentarily applying a predetermined third test signal to an input of said first modulator means in lieu of said first signal;

third memory means for storing a first modulated signal value which corresponds to said third test signal; and

third comparator means for producing a third error signal when said first modulated signal differs from said stored first modulated signal value more than a predetermined amount when said third test signal is applied to said first modulator means.

14. The power meter of claim 13 further including:

fourth memory means for storing a third converted signal value which corresponds to said third test signal;

fifth memory means for storing a fourth converted signal value which corresponds to said third test signal;

fourth compartor means for producing a fourth error signal when said first converted signal differs from said stored third converted signal value more than a predetermined amount when said third test signal is applied to said first modulator means; and fifth comparator means for producing a fifth error signal when said second converted signal differs from said fourth converted signal value more than a predetermined amount when said third test signal is applied to said first modulator means.

FIG.1.

MODES

| | NORMAL | TEST ONE | TEST TWO | TEST THREE |
|---|---|---|---|---|
| SWITCH S1 | OPEN | OPEN | ACTIVE | OPEN |
| SWITCH S2 | OPEN | OPEN | OPEN | ACTIVE |
| SWITCH S3 | CLOSED | OPEN | CLOSED | CLOSED |
| CONTROL A | HIGH (DISABLE) | LOW (ENABLE) | HIGH (DISABLE) | HIGH (DISABLE) |
| CONTROL B | HIGH (DISABLE) | HIGH (DISABLE) | LOW (ENABLE) | HIGH (DISABLE) |
| CONTROL C | HIGH (DISABLE) | HIGH (DISABLE) | HIGH (DISABLE) | LOW (ENABLE) |
| CONTROL D | HIGH (DISABLE) | HIGH (DISABLE) | 25% DUTY CYCLE | HIGH (DISABLE) |
| CONTROL E | HIGH (DISABLE) | HIGH (DISABLE) | HIGH (DISABLE) | 25% DUTY CYCLE |

FIG.2.